Europäisches Patentamt

European Patent Office

Office européen des brevets

(11) Numéro de publication: **0 255 416**
**A1**

# (12) DEMANDE DE BREVET EUROPEEN

(21) Numéro de dépôt: **87401483.0**

(22) Date de dépôt: **26.06.87**

(51) Int. Cl.⁴: **H 01 L 29/76**

(30) Priorité: **30.06.86 FR 8609441**

(43) Date de publication de la demande:
**03.02.88 Bulletin 88/05**

(84) Etats contractants désignés: **DE GB IT NL**

(71) Demandeur: **THOMSON-CSF**
**173, Boulevard Haussmann**
**F-75379 Paris Cédex 08 (FR)**

(72) Inventeur: **Vinter, Borge**
**THOMSON-CSF SCPI 19, avenue de Messine**
**F-75008 Paris (FR)**

**Tardella, Armand**
**THOMSON-CSF SCPI 19, avenue de Messine**
**F-75008 Paris (FR)**

(74) Mandataire: **Turlèque, Clotilde et al**
**THOMSON-CSF SCPI 19, avenue de Messine**
**F-75008 Paris (FR)**

(54) Dispositif semiconducteur à hétérojonction et double canal, son application à un transistor à effet de champ, et son application à un dispositif de transductance négative.

(57) Le dispositif semi-conducteur à hétérojonction comporte un double canal ayant une couche à mobilité forte (1), une couche barrière (2), et une couche à mobilité réduite (3), la couche barrière étant suffisamment mince pour que les porteurs puissent passer de la couche à mobilité réduite à la couche à mobilité plus forte par effet tunnel, lors de variations du champ électrique de polarisation de ce double canal.

Ce dispositif est applicable à la réalisation de transistors à effet de champ à temps de réponse rapide, sans variation de charge du canal, mais avec variation de la mobilité des porteurs. Il s'applique également aux dispositifs à transconductance négative utilisables comme oscillateur ou transistor complémentaire dans les circuits intégrés.

FIG_1

## Description

Dispositif semi-conducteur à hétérojonction et double canal, son application à un transistor à effet de champ, et son application à un dispositif de transductance négative

L'invention se rapporte au domaine des semi-conducteurs, et plus particulièrement à un transistor à effet de champ à hétérojonction, à temps de réponse rapide, ce temps de réponse étant déterminé non plus par une variation du nombre des porteurs du canal, mais par une variation de la vitesse de ces porteurs.

D'une manière générale, dans les transistors à effet de champ, la conductivité entre deux contacts source et drain est commandée par la tension appliquée à un troisième contact appelé grille. Classiquement dans ces transistors à effet de champ, la conductivité est commandée par la variation du nombre de porteurs de charge sous la grille, cette variation étant monotone avec la tension de grille.

Par exemple, dans un transistor du type "MESFET", l'épaisseur du canal conducteur augmente quand une tension positive est appliquée à la grille. De même dans un transistor à effet de champ à isolant "MOSFET" ou à hétérojonction "TEGFET", la densité des charges sous la grille augmente de façon monotone avec la tension appliquée à la grille.

Dans la demande de brevet européen n° 0091831, un transistor à effet de champ où la conductivité est déterminée et non plus par la variation du nombre des porteurs sous la grille mais par la variation de la vitesse de ces porteurs a été décrit. La solution proposée consiste à créer un canal, dans une couche de semi-conducteur, entre deux couches de semi-conducteurs à bande interdite plus grand; en introduisant un faible nombre d'impuretés donneurs d'un côté du canal et un fort nombre d'impuretés, donneurs et accepteurs de l'autre côté du canal. La conductivité de ce canal dépend de la distribution de charges. Une grille normale et une grille supplémentaire placées en contact arrière permettent de commander la position moyenne de la distribution de charges dans ce canal, en conséquence de quoi la mobilité des porteurs peut être modulée, sans variation du nombre de ces porteurs, du fait que ces porteurs son soit dans une zone à mobilité forte, soit dans une zone à mobilité réduite. Ce principe de fonctionnement a bien été démontré, mais la grandeur de l'effet est très faible même à très basse température, par exemple à 4°K température de l'hélium liquide.

L'invention a pour objet un dispositif semi-conducteur à hétérojonction et double canal, qui peut constituer un transistor à effet de champ à hétérojonctin, utilisant le même effet, c'est-à-dire une variation de vitesse des porteurs et non plus une variation de la quantité de ces porteurs. Mais, selon l'invention la structure est modifiée pour augmenter de manière très sensible cet effet de modulation de mobilité.

Selon l'invention, un dispositif semi-conducteur à hétérojonction comportant un substrat isolant, une hétérojonction dans laquelle s'étend un canal conducteur entre deux électrodes, et une couche supérieur à bande interdite grande, ce canal comportant une zone de mobilité faible et une zone de mobilité plus forte et sa conduction étant commandée par un champ électrique de polarisation qui attire les porteurs préférentiellement dans l'une ou l'autre zone, caractérisé en ce que le canal est consitué de deux couches de matériau semi-conducteur à bande interdite petite, l'une à mobilité forte, l'autre à mobilité réduite, séparées par une couche barrière à bande interdite grande, assez mince pour que les porteurs passent de la couche à mobilité forte à la couch à mobilité réduite et inversement par effet tunnel lors de la variation du champ de polarisation.

L'invention sera mieux comprise et d'autres caractéristiques apparaitront à l'aide de la description qui suit en référence aux figures annexées.

La figure 1 est le schéma d'un transistor à effet de champ à hétérojonction selon une première variante de l'invention;

La figure 2 est le schéma en coupe d'une seconde variante du transistor à effet de champ à hétérojonction selon l'invention;

Les figures 3a et 3b montrent schématiquement la distribution de charges respectivement dans le cas où les porteurs sont dans la zone à mobilité élevée, et dans le cas où les porteurs sont dans la zone à mobilité réduite.

La figure 4 représente la distribution de charges dans le cas où le dispositif semi-conducteur suivant l'invention est utilisé avec variation du nombre de porteurs comme dispositif à transconductance négative.

La figure 5 représente la conductance G(s) du canal, par unité de surface s, en fonction de la densité des porteurs, et suivant le champ de polarisation appliqué.

La figure 6 représente la variation de conductivité en fonction du nombre de porteurs d'une part dans la structure suivant l'invention, et d'autre part dans la structure la plus proche selon l'art antérieur.

D'une manière générale, dans un transistor à effet de champ classique, un paramètre important pour le temps de réponse ou encore pour la fréquence maximale de gain est le produit de la capacité source-grille et des résistances d'accès de source et de grille. Par principe un transistor classique à effet de champ exige une variation du nombre de porteurs dans le canal. Ce paramètre représente donc et limite intrinsèque à la rapidité du transistor. Comme indiqué ci-dessus un dispositif qui en principe éliminerait cette variation de charges du canal a été proposé dans la demande de brevet européen n° 0091831. En créant un canal dans une couche de semi-conducteur, par exemple dans une couche d'arséniure de gallium, GaAs, entre deux couches de semi-conducteur à bande interdite plus grande, par exemple des couches d'alliage d'aluminium et d'arséniure de gallium, et en introduisant un faible nombre d'impuretés, donneuses, d'un côté du canal et un fort nombre d'impuretés, donneuses et accepteuses, de l'autre côté du canal, la conductivité du canal dépend alors non plus de la quantité des porteurs mais de la distribution de ces porteurs dans le canal. La commande de la position moyenne de la distribution des charges par une grille normale et un contact sur la face arrière du substrat entre lesquels on applique un champ de polarisation, permet de moduler la mobilité des porteurs dans le canal sans en faire varier le nombre. Comme indiqué ci-dessus, la grandeur de l'effet est faible même à basse température.

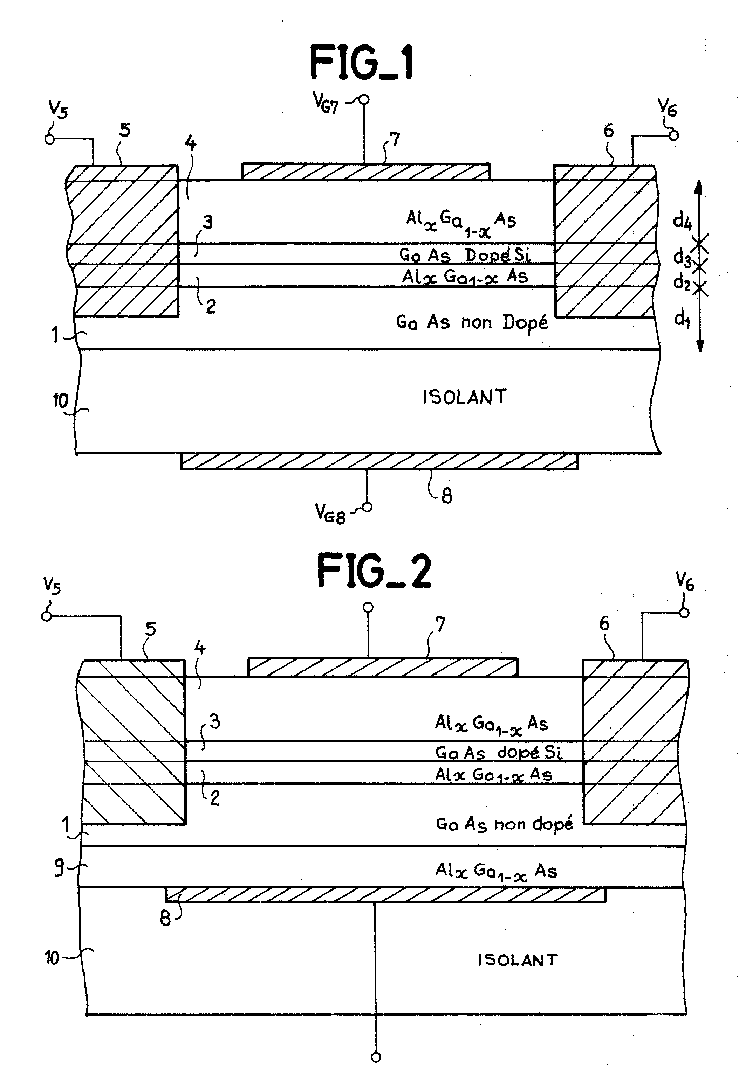

La figure 1 représente le dispositif semi-conducteur à hétérojonction et double canal selon l'invention. Ce dispositif semi-conducteur comporte un substrat isolant 10 sur lequel on fait croitre, typiquement par épitaxie par jet moléculaire, des couches de semi-conducteurs différents formant des hétérojonctions. La première couche déposée, 1, est une couche de matériau semi-conducteur à band interdit petite, non dopée, et à mobilité élevée. Cette couche peut être par exemple une couche d'arséniure de gallium, GaAs, d'épaisseur $d_1$ voisine de 1 micromètre.

Sur cette couche on fait croitre une seconde couche de semi-conducteur, 2, à bande interdite grande, non dopée et d'une épaisseur $d_2$ suffisamment faible pour permettre un effet tunnel quantique des porteurs à travers la couche. Typiquement cette couche peut être constituée d'un alliage d'aluminium et d'arséniure de gallium, $Al_xGa_{1-x}As$, d'épaisseur comprise entre 50 et 80 Å par exemple.

Sur cette seconde couche on fait croitre une couche de semi-conducteur à bande interdite petite, 3, fortement dopée, et d'une épaisseur $d_3$ suffisamment petite pour permettre la désertion de porteurs libres de la couche. Cette couche peut être typiquement une couche d'arséniure de gallium GaAs dopée par des atomes de silicium, Si, à $10^{18}$ atomes par $cm^3$ par exemple, sur une épaiseur de l'ordre de 50 Å.

Cette couche est ensuite recouverte d'une couche de semi-conducteur à bande interdite grande, éventuellement dopée sur une partie ou sur la totalité de son épaisseur $d_4$, $d_4$ étant déterminée de manière connue pour être désertée de porteurs libres. Cette couche peut être une couche d'alliage d'aluminium et d'arséniure de gallium, comme la couche 2, sur une épaisseur de quelques centaines Å.

Cette structure est alors complétée par des contacts latéraux source et drain, 5 et 6 respectivement, un contact sur la couche supérieure 4 formant une grille 7, et un contact arrière 8 sur la substrat isolant, déposé éventuellement après amincissement.

Le fonctionnement de ce dispositif semi-conducteur à hétérojonction est le même que celui de transistor à vitesse modulée décrit dans la demande de brevet européen en référence ci-dessus : en appliquant des tensions sur les deux grilles 7 et 8, $V_{G7}$ et $V_{G8}$ afin d'avoir un canal conducteur entre source et drain, et en modulant ces tensions de grille en synchronisation, la résistance entre source et drain est modifiée sans changer le nombre de porteurs dans le canal, mais simplement en confinant les porteurs dans l'une ou l'autre couche conductrice de mobilités différentes. Du fait de la barrière entre les deux couches, le confinement est beaucoup plus net que dans la structure antérieure et la variation de mobilité constatée est beaucoup plus importante, sans que la rapidité du transfert de charges d'une partie du canal à l'autre ne soit compromise, car l'épaisseur et la hauteur de la barrière sont choisies pour que le transfert soit efficace par effet tunnel. Ainsi, le transfert de porteurs par effet tunnel est utilisé selon l'invention pour faire varier de manière contrôlée la mobilité des porteurs dans un canal qui s'étand parallèlement à la barrière.

Une deuxième variante du dispositif semi-conducteur à hétérojonction et double canal selon l'invention est représentée sur la figure 2. Cette figure montre, comme la précédente, un substrat isolant 10 et une hétérojonction constituée des quatre couches 1, 2, 3 et 4 décrites ci-dessus, respectivement à bande interdite petite et mobilité forte (1), à bande interdite grande (2), à bande interdite petite et mobilité réduite (3), et enfin à bande interdite grande (4), mais le substrat isolant est séparé de la couche conductrice non dopée 1 par une couche supplémentaire à bande interdite grande, 9, constituée par exemple comme les couches 2 et 4 d'un alliage d'aluminium et d'arséniure de gallium. Cette structure permet de prendre le contact arrière non plus sur la face arrière de l'isolant 10 comme sur la figure 1 mais à l'interface entre le substrat isolant 10 et la couche supplémentaire à bande interdite grande 9. Une telle structure peut faciliter la commande en rapprochant l'électrode arrière de la structure active et serait mieux adaptée pour être utilisée dans un circuit intégré.

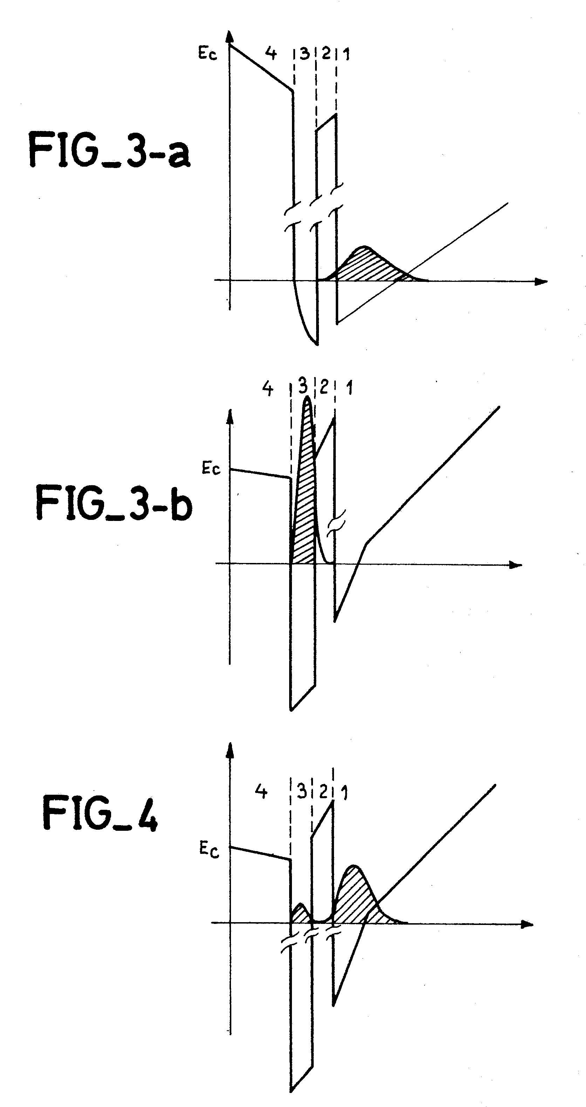

Les figures 3a et 3b illustrent le fonctionnement du dispositif semi-conducteur à hétérojonctions et double canal décrit ci-dessus. Elles représentent respectivement le minimum d'énergie des bandes de conduction, $E_c$, dans les différentes couches de semi-conducteur, et la répartition des porteurs (zones hachurées) dans ces couches respectivement lorsque les porteurs sont confinés dans la couche à mobilité forte et lorsqu'ils son confinés dans la couche à mobilité réduite.

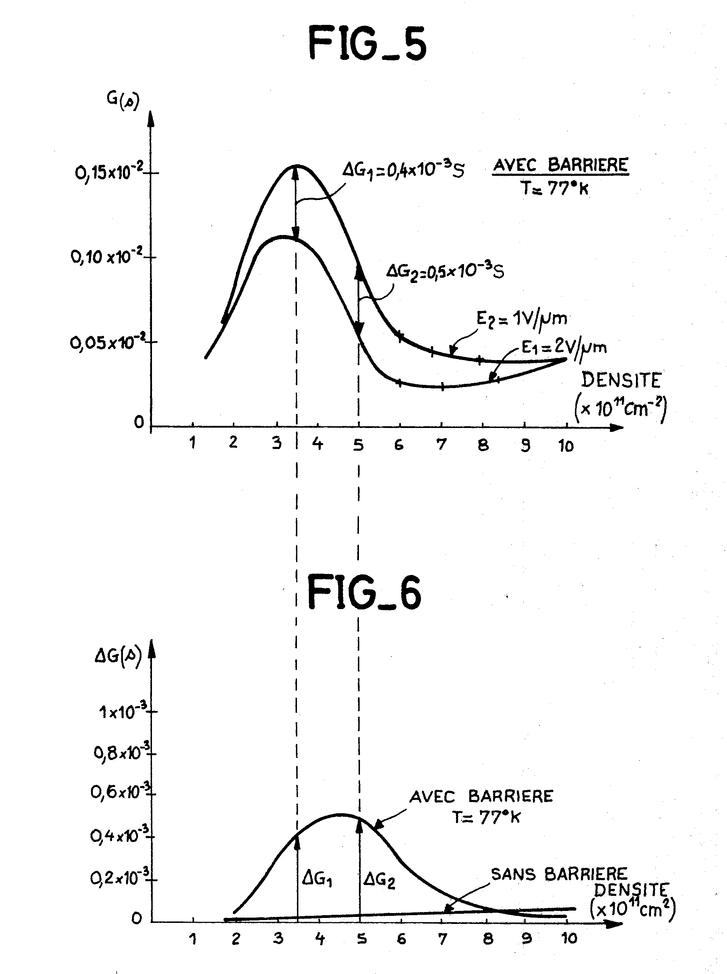

La figure 5 représente la conductance moyenne $G(s)$ résultante par unité de surface s, du dispositif semi-conducteur à hétérojonctions suivant l'invention, avec son double canal muni d'une barrière, en fonction de la densité de porteurs. Lorsqu'un premier champ électrique $E_1$ de l'ordre de 2 volts par micromètre est appliqué au dispositif, entre la grille arrière 8 et la source 5, la conductance varie en fonction de la densité contrôlée par la tension entre la grille 7 et la source, les porteurs restant plutôt confinés dans la zone à mobilité réduite. La valeur maximale de la conductivité est de l'ordre de $0,11 \times 10^{-2}$ S (S = Siemens unité de conductivité et de conductance) pour une densité de l'ordre de 3 à 3,5 $\times 10^{11}/cm^2$. Pour une deuxième valeur de champ électrique appliquée $E_2$ de l'ordre de 1 volt par micromètre, les porteurs passent plutôt dans la zone à mobilité forte, et la conductance varie en fonction de la densité suivant une courbe de même allure que la première mais à des niveaux supérieurs de conductivité, la valeur maximale étant alors de l'ordre de $0,5 \times 10^{-2}$S. La figure 6 représente la variation de conductivité G(s) lorsque l'on passe de la première valeur de champ à la seconde valeur de champ, en fonction de la densité, d'une part avec la structure à double canal et barrière selon l'invention, et d'autre part avec la structure à double zone mais sans barrière décrite dans l'art antérieur. Cette figure montre que la variation de conductance susceptible d'etre obtenue est, lorsque la densité surfacique de porteurs est de l'order de 3 à $5 \times 10^{11}$ porteurs par cm², dans un rapport 25 de la structure antérieure à la structure selon l'invention (de $0,02 \times 10^{-2}$S à $0,5 \times 10^{-3}$S).

Cette structure est particulièrement applicable à un transistor à effet de champ à temps de réponse élevé, puisqu'il est possible de l'utiliser à densité constant de porteurs pour faire varier la conductance dans un rapport élevé, et donc sans le retard du à l'effet capacitif qui serait lié à une augmentation de la charge du canal.

Mais comme le montre la figure 5, la conductance obtenue avec un tel dispositif peut diminuer lorsque l'on augmente le nombre de porteurs: la transconductance est alors négative. Le dispositif semi-conducteur à hétérojonction et double canal décrit ci-dessus est donc également applicable à un dispositif à transconductance négative ayant, dans une gamme de tension de grille une réduction de conductivité pour une augmentation du nombre de porteurs du canal conducteur. Un tel dispositif réalise donc l'action d'un transistor complémentaire. Le dispositif proposé à canal d'électrons augmente la résistance source-drain en appliquant une tension de grille positive, comme c'est le cas d'un transistor classique à canal de trous. La partie du canal fortement dopée, c'est-à-dire la couche 3, doit être suffisamment mince pour être un puits quantique, le mouvement des porteurs dans la direction perpendiculaire aux couches étant alors quantifié. La transconductance négative est obtenue par l'effet suivant: la tension de grille commande la densité de porteurs dans le canal comme dans tout transistor à effet de champ. A basse densité les porteurs sont tous dans la partie à haute mobilité du canal, c'est-à-dire répartis comme représenté sur la figure 3a décrite ci-dessus. La transductance est alors positive. En augmentant la densité, le niveau quantique le plus bas du puits quantique s'approche du niveau de Fermi et des niveaux les plus bas de la partie non dopée 1 du canal. Dans ce cas la partie dopée du canal, c'est-à-dire la couche 3, commence à se peupler, ce qui réduit la mobilité moyenne du canal. Mais l'effet important vient alors du fait que part effet tunnel résonnant, les niveaux des deux parties conductrices du canal 1 et 3 interagissent, et que les porteurs ne sont plus strictement dans l'une ou l'autre partie du canal. Ils sont tous dans les deux parties du canal comme représenté sur la figure 4 et subissent tous une diffusion forte due aux impuretés de la partie dopée du canal, c'est-à-dire de la couche 3. La réduction de mobilité qui en découle peut être suffisamment forte pour que même la conductance du canal soit réduite bien que le nombre de porteurs soit augmenté. Enfin si l'on continue à augmenter la densité de porteurs, les porteurs rajoutés seront préférentiellement dans la partie dopée 3 du canal et la transconductance sera de nouveau positive.

Ce transfert par effet tunnel résonnant fait varier de manière contrôlée la mobilité des porteurs parallèlement à la barrière, puisque le courant est dans le sens source-drain. La condition pour que ce fonctionnement existe est que l'épaisseur de la couche conductrice à mobilité réduite, 3, soit si mince que le mouvement perpendiculaire soit quantifié. et que, proche du pincement du canal, son niveau quantique le plus bas soit audessus du niveau le plus bas dans la couche conductrice non dopée à forte mobilité. Typiquement pour cette utilisation l'épaisseur $d_3$ de cette couche est de l'ordre de 50 Å avec les materiaux décrits ci-dessus, c'est-à-dire arséniure de gallium dopé par des atomes de silicium. De plus, le concact arrière n'est pas nécessaire. Cet effet sera d'autant plus important que la température sera basse. Selon les résultats de calculs montrés dans la figure 5 le rapport entre la conductance maximale et la conductance minimale d'un tel canal obtenue par une augmentation de la densité des porteurs peut être de l'ordre de 3 à 6 77°K.

L'invention n'est pas limitée aux modes de réalisation précisément décrits et représentés. En particulier il est possible d'utiliser d'autres matériaux que ceux décrits, par exemple des couches d'InP pour les couches à grand gap, et des couches de $In_{0,47}Ga_{0,53}$ As pour les couches à petit gap, ces proportions d'indium et de gallium étant nécessaires pour avoir la même dimension de mailles pour les couches superposées et donc des interfaces de bonne qualité entre les différentes couches semi-conductrices de l'hétérojonction.

Enfin, bien qu'il ait été considéré dans la description de l'invention, de façon implicite, que les porteurs du canal étaient des électrons et les atomes dopants des donneurs, il est clair que l'invention s'applique de manière analogue aux applications pour lesquelles les porteurs sont des trous et les dopants sont des accepteurs.

**Revendications**

1. Dispositif semi-conducteur à hétérojonction comportant un substrat isolant (10), une hétérojonction dans laquelle s'étend un canal conducteur entre deux électrodes (5, 6) et une couche supérieure (4) à bande interdite grande, ce canal comportant une zone de mobilité faible et une zone de mobilité plus forte et sa conduction étant commandée par un champ électrique de polarisation qui attire les porteurs préférentiellement dans l'une ou l'autre zone, caractérisé en ce que le canal est constitué de deux couches de matériau semi-conducteur à bande interdite petite, l'une à mobilité forte (1), l'autre à mobilité réduite (3), séparées par une couche barrière (2) à bande interdite grande, assez mince pour que les porteurs passent de la couche à mobilité forte à la couche à mobilité réduite et inversement par effet tunnel lors de la variation du champ de polarisation.

2. Dispositif selon la revendication 1, caractérisé en ce que la couch à mobilité forte (1) est une couche de matériau semi-conducteur non dopé, tandis que la couche à mobilité réduite (3) est une couche de matériau semi-conducteur fortement dopé.

3. Dispositif selon l'une des revendications 1 et 2 caractérisé en ce que la couche barrière (2) est une couche d'alliage non dopée.

4. Dispositif selon l'une quelconque des revendications 1 à 3, caractérisé en ce que la couche à mobilité élevée (1) est une couche d'arseniure de gallium non dopé, la couche de mobilité réduite (3) est une couche d'arséniure de gallium dopé par des atomes de silicium, et les couches à bande interdite grandes (2, 4) sont des couches d'alliage d'arséniure de gallium et d'aluminium.

5. Dispositif selon la revendication 1, caractérisé en ce qu'une couche supplémentaire à bande interdite grande (9) est prévue entre le substrat isolant (10) et la couche correspondante de matériau semi-conducteur à bande interdite petite (1).

6. Dispositif selon l'une des revendications 1 à 5, caractérisé en ce que la couche à bande interdite grande (4) en contact avec la couch à bande interdite petite et à mobilité réduite (3), est dopée sur au moins une partie de son épaisseur.

7. Application du dispositif semi-conducteur à hétérojonction selon l'une des revendications 1 à 6, à un transistor à effet de champ, caractérisé en ce que la couche barrière du canal a une épaisseur permettant un transfert de porteurs par effet tunnel, typiquement de l'ordre de 50 à 80 Å, le champ électrique de polarisation étant appliqué entre une électrode (8) disposée sur le substrat isolant (10) et une électrode (7) disposée sur la couche supérieure (4) à bande interdite grande, de telle manière que le nombre des porteurs dans le canal ne varie pas lors de changements de polarisation.

8. Application du dispositif semi-conducteur à hétérojonction selon l'une des revendications 1 à 6, à un dispositif à transconductance négative, caractérisé en ce que la couche conductrice à mobilité réduite (3) a une épaisseur assez mince, typiquement 50 Å, pour que les deux couches de matériau semi-conducteur à bande interdite petite et à mobilités différentes intéragissent par effet tunnel résonnant lorsque la densité des porteurs dépasse un premier seuil, commandé par augmentation de la polarisation d'une électrode (7) disposée sur la couche supérieure à bande interdite grande (4), mais reste inférieure à un second seuil au délà duquel l'intéraction par effet tunnel résonnant est supprimée.

0255416

# FIG_1

# FIG_2

0255416

FIG_3-a

FIG_3-b

FIG_4

0255416

# FIG_5

Axes: $G(\rho)$ vs DENSITE $(\times 10^{11} cm^{-2})$

$\Delta G_1 = 0,4 \times 10^{-3} S$  AVEC BARRIERE $T \simeq 77°K$

$\Delta G_2 = 0,5 \times 10^{-3} S$

$E_2 = 1 V/\mu m$

$E_1 = 2 V/\mu m$

# FIG_6

Axes: $\Delta G(\rho)$ vs DENSITE $(\times 10^{11} cm^2)$

AVEC BARRIERE $T = 77°K$

$\Delta G_1$  $\Delta G_2$

SANS BARRIERE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | EP-A-0 155 215 (FUJITSU LTD) <br> * Page 1, lignes 1-16; figure 7 * | 1-6 | H 01 L 29/76 |
| A | INTERNATIONAL ELECTRON DEVICES MEETING - IEDM Technical Digest, Washington, D.C., 5-7 décembre 1983, pages 107-110, Electron Devices Society of IEEE; L. LORECK et al.: "Deep level analysis in (AlGa)As-GaAs MODFETs by means of low frequency noise measurements" <br> * Figure 1 * | 1 | |
| A | JAPANESE JOURNAL OF APPLIED PHYSICS, vol. 21, no. 6, juin 1982, pages L381-L383, Tokyo, JP; H. SAKAKI: "Velocity-modulation transistor (VMT) - A new field-effect transistor concept" <br> * Page 383, colonne 2 * | 8 | DOMAINES TECHNIQUES RECHERCHES (Int. Cl.4) <br><br> H 01 L 29 |
| A | GB-A-2 168 847 (SONY) <br> * Figure 2 * | 1 | |

Le présent rapport de recherche a été établi pour toutes les revendications

| Lieu de la recherche | Date d'achèvement de la recherche | Examinateur |
|---|---|---|
| LA HAYE | 06-01-1987 | PELSERS L. |